# EUROPEAN PATENT SPECIFICATION

(11) **EP 0 551 377 B1**
(45) Date of publication and mention of the grant of the patent: **03.05.1995**
(21) Application number: 91918023.2
(22) Date of filing: 18.09.1991
(51) Int. Cl.: C09J 5/06, H01L 31/18

(54) **METHOD OF LAMINATING COMPOSITE STRUCTURES FOR PHOTOVOLTAIC DEVICES**
VERFAHREN ZUM LAMINIEREN VON VERBUNDSTRUKTUREN FÜR PHOTOVOLTAISCHE ANORDNUNGEN
PROCEDE POUR STRATIFIER DES STRUCTURES COMPOSITES POUR DISPOSITIFS PHOTOVOLTAIQUES

(30) Priority: 01.10.1990 US 590775; 29.11.1990 US 619482
(43) Date of publication of application: 21.07.1993
(73) Proprietor: UNITED SOLAR SYSTEMS CORPORATION, Troy, MI 48084 (US)
(72) Inventor: NATH, Prem, Rochester Hills, MI 48307 (US); LAARMAN, Timothy, Almont, MI 48003 (US); VOGELI, Craig, New Baltimore, MI 48047 (US)
(74) Representative: MacDougall, Donald Carmichael
(86) International application number: US9106769
(87) International publication number: WO9206144

(56) References cited:
- GB-A- 2 042 802
- US-A- 3 767 500
- US-A- 4 087 300
- US-A- 4 382 833
- US-A- 4 499 658
- US-A- 4 514 583
- US-A- 4 773 944

## Description

### Background of the Invention

### Field of the Invention

This invention relates generally to lamination of semiconductor devices and their substrates and, more particularly, to a method of making a composite photovoltaic device substrate having a metallic support layer and an insulating layer disposed thereon and to a method for laminating thin film photovoltaic devices with a flexible protective sheet.

### Description of the Relevant Prior Art

Large area arrays of thin film semiconductor devices may be fabricated from a plurality of electrically isolated, discrete circuit elements. Such devices may include diodes, triodes, transistors, photocells, et cetera. The plurality of discrete circuit elements are deposited and interconnected upon the single large area substrate. In this manner, large area logic arrays, memory storage devices, photovoltaic generators, display devices, et cetera, may be continuously and economically fabricated.

Semiconductor devices are generally fabricated upon substrates which are adapted to provide (1) structural support to subsequently deposited regions of thin film metallic, electronic or semiconductor layers and (2) electrical isolation between adjacent regions of those layers. Since the deposited material is, typically, less than a micron in thickness, these layers must be supported by the substrate so that they will have sufficient rigidity for handling during subsequent fabrication, installation and repair. Typically, these thin film semiconductor devices are produced by roll-to-roll processing, with a roll of substrate becoming a single device. It is often desirable to divide such a large area device into a plurality of circuit elements or regions. Because adjacent plural circuit elements formed by the thin film regions on a single substrate may be horizontally separated from one another by distances as small as a micron, good electrical isolation between those circuit elements and regions is necessary to prevent undesirable electric leakage and short circuits therebetween. Further, in semiconductor devices employing a metallic substrate, an electrically insulating layer is necessary to vertically separate the thin film layers from said metallic substrate to prevent short circuiting current from one element or region to another through the common substrate. Therefore, electrical insulation and isolation must be provided in both the vertical and the horizontal directions in order to form the many types of operative semiconductor devices it is possible to manufacture utilizing thin film techniques.

Such thin film semiconductor devices may be commercially produced by using thin, continuous, flexible substrates in continuous processing techniques. By using continuous, flexible substrates, thin film electronic, metallic and semiconductor layers may be continuously deposited thereon in a roll-to-roll process. In this manner, thin film semiconductor devices may be produced in a cost-effective manner.

Thin, metallic substrates offer several advantages in the roll-to-roll production of thin-film, semiconductor devices: they (1) are rigid yet flexible; (2) may be made relatively thin without losing rigidity; (3) may be provided with a smooth surface finish; and (4) are relatively inexpensive. Since such thin metallic substrates provide neither horizontal electrical isolation when fabricating semiconductor devices from contiguous circuits and circuit elements, nor vertical electrical isolation when fabricating semiconductor devices from multiple layers of metallic, electronic or semiconductor material deposited successively onto the substrate, composite substrates having a base metallic layer with an insulating coating deposited thereon have been devised. An example of such a composite substrate is disclosed and claimed in U.S. Patent No. 4,514,583. The referenced patent discloses a relatively thick support layer having a substantially planar surface and a relatively thin, flexible, substantially defect-free, electronically insulating layer formed of a synthetic polymeric material deposed atop the planar surface of the support layer.

Composite substrates, such as that disclosed in U.S. Patent No. 4,514,583, have proven satisfactory from both the manufacturing and performance standpoints. These composite substrates possess the desired operating characteristics enumerated above, and are readily adaptable to roll-to-roll fabrication. Hence, their use is clearly desirable in thin film, semiconductor applications. However, the composite substrates, themselves, must be fabricated prior to depositing the semiconductor layers atop the substrates. To that end, a variety of conventional methods are employed. For example, U.S. Patent No. 4,514,583 discloses a method of depositing a layer of, for example, a polyamide (amide) insulating coating atop a stainless steel support layer by means of a solvent coating process. In such a process, the polyamide (amide) is dissolved in an appropriate solvent, coated onto the stainless steel support layer, and then dried to remove the solvent. An additional curing step may be required to cross link and harden the polyamide (amide) insulating layer.

However, the solvent coating process of depositing the polyamide (amide) layer onto the support layer has at least two important drawbacks: (1) films deposited by solvent coating contain significant solvent residues which are prone to outgassing during the subsequent deposition of the multiple layer semiconductor elements, which is carried out under vacuum. Obviously, outgassing from the solvent residue on the substrate can contaminate the deposition chambers and seriously lower the quality of the subsequently deposited thin film layers. (2) solvent coating processes tend to produce films with pin-hole defects. Pin-hole defects in the insulating layer of a composite substrate will compromise the dielectric integrity of the device. Additionally, films deposited by solvent coating are limited in thickness, which, in turn, limits the charge capacity of the device.

It is also known to laminate stock polyamide (amide) film onto the metallic substrate. Stock polyamide (amide) film is available from the Dupont Chemical Company and is sold under the name Kapton®. A bondable Kapton is available which has a layer of polytetrafluoroethylene (PTFE) deposited thereon. The PTFE serves as an adhesive to bond the insulating layer to the stainless steel support layer.

The prior art techniques for bonding the bondable insulating layer to the metallic substrate involve the simultaneous application of heat and pressure. Typically, the support layer and the insulating layer, which are both supplied in the form of rolls, are unrolled and the insulating layer is placed atop the support layer. There may be trapped air between the two layers. Since such trapped air causes defects in the fabricated semiconductor, it is necessary to eliminate it. To this end, the two materials may be run through a hot roller which simultaneously heats the bonding layer to its activation temperature, and squeezes out air trapped between the layers. Alternatively, the two layers may be pressed together flat between heated platens while being subjected to an at least partial vacuum to remove the trapped air. However, this flat processing technique is useful only in the production of smaller sized devices.

Obviously, the hot roller step is undesirable from a production standpoint. The hot roller must be carefully adjusted for both correct pressure and temperature. Moreover, heating throughout the hot roller is likely to be less than uniform, thus producing less than satisfactory results. Furthermore, the hot roller equipment is expensive, and is not required for any other step in conventional roll-to-roll production of thin film semiconductor devices. If the hot roller step could be eliminated, it would increase both the efficiency of the production process and the quality of the product attained, and lower the cost of manufacture.

Thin film photovoltaic devices are one type of semiconductor device which may be fabricated from a variety of materials including silicon alloys, germanium alloys, cadmium telluride, copper indium diselenide and other such materials. These devices are thin and flexible and may be readily cut to a variety of sizes and shapes. Thin film photovoltaic devices may be interconnected in a variety of configurations to provide appropriate voltage and power outputs for particular applications. In general, thin film photovoltaic devices are encapsulated between protective layers prior to use, in order to protect them from mechanical damage or ambient atmospheric conditions. Additionally, thin film photovoltaic devices are frequently laminated to relatively rigid support members for particular applications. For example, photovoltaic roofing panels are manufactured by laminating a thin film photovoltaic device to sheets of aluminum, galvanized steel or other such roofing material.

In general, the photovoltaic device is laminated between a protective, transparent top coat and a supporting substrate by means of a layer of thermoplastic polymer or the like and the lamination process is carried out by a vacuum lamination process. Typically, the device is sandwiched between encapsulating layers and a flexible, air impermeable membrane is placed over the device. Air is evacuated from beneath the membrane and the pressure of the atmosphere, acting through the membrane, compresses the device. The device is heated while under compression to complete the lamination. While the results of such lamination are generally adequate, the lamination process represents a significant expenditure of capital resources and the lamination equipment occupies large areas of valuable floor space in a manufacturing environment. Additionally, particular skill in operation of the lamination equipment is necessary.

The present invention is also directed to a process whereby an interleaved assemblage of photovoltaic cells and encapsulating materials is rolled together and laminated with or without an evacuation step. The method of the present invention is simple and inexpensive and may be readily integrated with techniques for the continuous production of large area photovoltaic devices. These and other advantages of the present invention will be readily apparent from the drawings, discussion and description which follow.

### Summary of the Invention

Disclosed and claimed herein is an improved method of producing semiconductor devices on a composite substrate which includes a metallic support material and a layer of insulating material deposed thereupon. This method utilizes an elongated sheet of a support material and an elongated sheet of insulating material, both preferably although not necessary, provided in roll form. The insulating layer may be bondable with a thermoplastic high temperature, hot-melt adhesive deposed thereon. In the method of the present invention, the roll of metallic support material is unwound while being simultaneously subjected to a tensioning force. The roll of bondable insulating material is also unwound. The tensioned metallic substrate material and the insulating material are then interwound together upon a common roller to form a composite roll of alternating layers of tensioned substrate and insulating material.

The composite roll is then heated to a temperature sufficient to raise the hot-melt adhesive to its activation temperature for a sufficient period of time to bond the insulating layer to the support substrate. The roll of bonded material is then removed from the heat. It may be then unrolled and transported through one or more deposition chambers for the deposition of thin film layers thereon to form various semiconductor devices. In an equally preferred, but alternative embodiment, the insulating material may be provided without a hot-melt adhesive. In that case, the composite roll is heated to a temperature (approximately 400° C. for a polyamide (amide) material) sufficient to cause surface tackiness of the insulating layer, which will then bond to the support material kept under tension.

Since the roll of metallic substrate is kept under tension while the two layers are interwound together on the common roller, the problem of trapped air is eliminated since any trapped air between the layers is forced out during the tension rolling process. By utilizing the teachings of the present invention, it is possible to fabricate a composite substrate useful for semiconductor devices without using hot rollers, heated platens or a wet coating process. No additional expensive equipment is utilized since tensioning rollers and heat sources are utilized in various other points of manufacture of thin film semiconductor devices. The process yields a continuous, substantially pin-hole free insulating layer which will not outgas during subsequent processing.

The process of the present invention may also be used for encapsulating photovoltaic, and other semiconductor, devices. A roll of adhesive material is provided, the device is disposed on the roll; a roll of front encapsulant material is provided and a roll of back encapsulant material is provided. The materials are rolled together to provide a layered structure comprising, in order, front encapsulant material, photovoltaic device, adhesive and back encapsulant material. The layered structure is rolled up under tension so as to provide a tightly wound composite roll of said layered structure. In the final step, the roll is heated for a period of time sufficient to activate the adhesive material.

In a further embodiment of the invention, a second roll of adhesive material is provided and interleaved between the front encapsulant material and photovoltaic device prior to winding. In yet other embodiments, the front encapsulant material may be precoated with an adhesive material. In yet other embodiments, further layers of materials such as a dielectric material may also be interleaved into the structure prior to rolling.

Heating may be accomplished in an oven. The adhesive generally comprises a thermally activated cross-linking adhesive such as an ethylene vinyl acetate polymer or a hot melt adhesive. The photovoltaic devices may comprise discrete cells or they may comprise a module of interconnected cells.

### Brief Description of the Drawings

The following detailed description may best be understood by reference to the following drawings in which:
FIGURE 1 is a fragmentary cross-sectional view of a thin film tandem photovoltaic device comprising a plurality of p-i-n type cells stacked atop the composite substrate of the instant invention;
FIGURE 2 is a diagrammatic representation of a multiple glow discharge chamber deposition system adapted for the continuous production of photovoltaic devices of the type shown in FIGURE 1, by depositing semiconductor material upon the composite substrate of the instant invention;
FIGURE 3 is a perspective view of a roll of composite substrate produced according to the method of the present invention with a portion thereof cutaway to illustrate the multi-layered structure thereof;
FIGURE 4 is a schematic illustration of the method of forming a composite substrate of the present invention showing the various steps thereof;
FIGURE 5 is a schematic illustration of one embodiment of photovoltaic device lamination process implemented in accord with the present invention;
FIGURE 6 is a schematic illustration of a second embodiment of photovoltaic device lamination process implemented in accord with the present invention; and
FIGURE 7 is a cross-sectional view of an encapsulated photovoltaic device according to the present invention.

### Detailed Description of the Drawings

### 1. The Photovoltaic Cell

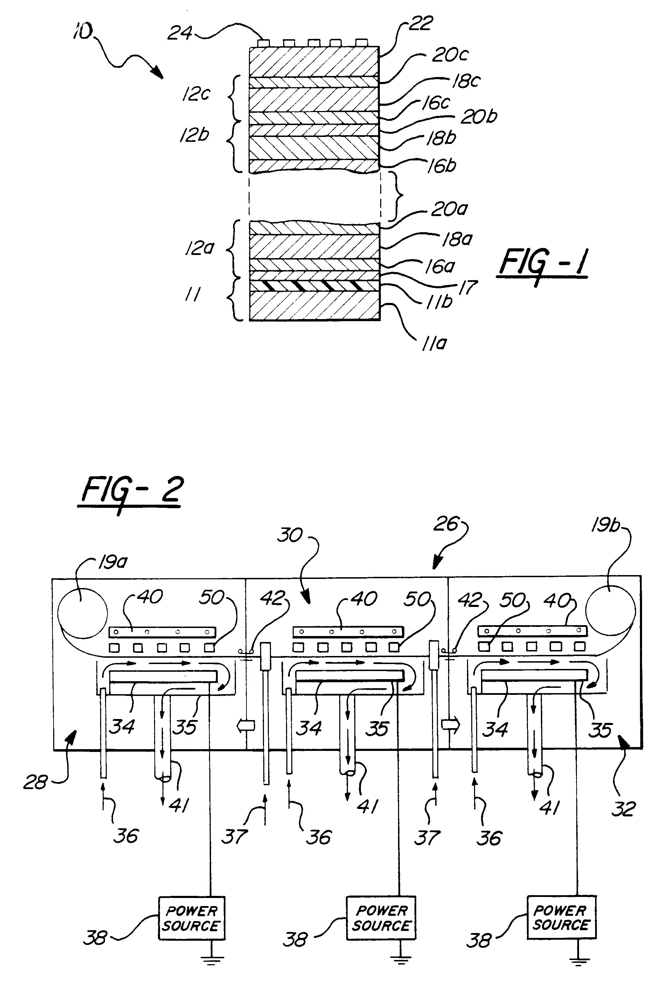

Referring now to the drawings and particularly to Figure 1, a photovoltaic cell, formed of a plurality of successive p-i-n layers, each of which includes, in the preferred embodiment, an amorphous semiconductor alloy, is shown generally by the numeral 10. The method of forming a composite substrate of the instant invention was developed for the fabrication of thin film electronic devices such as the photovoltaic device shown in Figure 1, and is especially well adapted for use in a continuous deposition process wherein semiconductor layers are continuously deposited onto a substrate in successive isolated deposition chambers. While the present invention may also be utilized for the encapsulation of a variety of photovoltaic devices; the thin film, large area, flexible photovoltaic devices of Figure 1 are particularly well suited for use in the present invention.

More particularly, Figure 1 shows a p-i-n type photovoltaic device such as a solar cell made up of individual p-i-n type cells 12a, 12b and 12c. Below the lower most cell 12a is a composite substrate 11 consisting of a relatively thick support layer 11a and a flexible, relatively thin insulating layer 11b, both of which will be described in greater detail hereinbelow.

An electrically conductive bottom, electrical contact layer 17 is operatively disposed atop the insulating layer 11b so as to be in electrical communication with the semiconductor cells 12a, 12b, 12c formed thereatop. It is to be noted at this point that, in some cases, it is desirable to include a specular or diffuse back reflector layer as part of the substrate 11 of the photovoltaic cell 10. This back reflector layer if specular, may be the bottom contact 17, or, if diffuse, is disposed immediately beneath or above the bottom contact 17, so that it functions to scatter and redirect light passing through the active regions of the photovoltaic cell.

Each of the cells 12a, 12b and 12c are fabricated with an amorphous semiconductor body containing at least a silicon or germanium alloy. Each of the semiconductor bodies includes an n-type conductivity layer 20a, 20b and 20c; an intrinsic layer 18a, 18b and 18c; and a p-type conductivity layer 16a, 16b and 16c. As illustrated, cell 12b is an intermediate cell and, as indicated in Figure 1, additional intermediate cells may be stacked atop cells. Also, although p-i-n cells are illustrated, n-i-p cells may be similarly employed. The composite substrate may also be used in deposition apparatus adapted to produce any type of thin film electronic device in either a continuous or batch mode of production.

It is to be understood that following the deposition of the semiconductor layers, a further deposition process may be either performed in a separate environment or as part of a continuous process. In this step, TCO (transparent conductive oxide) layer 22 is added. This layer functions as the upper electrode, and cooperates with the bottom contact layer 17 to establish a current path through the device 10. An electrode grid 24 may be added to the device where the cell is of a sufficiently large area, or if the conductivity of the TCO layer 22 is insufficient. The grid 24 shortens the carrier path through the TCO and thus increases the conduction efficiency.

### II. The Multiple Glow Discharge Deposition Chamber Apparatus

Turning now to Figure 2, a diagrammatic representation of a multiple glow discharge chamber deposition apparatus for the continuous production of photovoltaic cells is generally illustrated by the reference numeral 26. The apparatus 26 includes a plurality of isolated, dedicated deposition chambers, each chamber of which is interconnected by a gas gate through which sweep gases and a web of substrate material 11 are adapted to pass.

The apparatus 26 is adapted to mass produce, in the preferred embodiment, large area, amorphous semiconductor cells having a p-i-n type configuration on the surface of a substrate material 11 which is continually fed therethrough. To deposit the amorphous semiconductor layers required for producing multiple p-i-n type layer cells, the apparatus 26 includes at least one triad of deposition chambers. Each triad of deposition chambers comprises: a first deposition chamber 28 in which a p-type conductivity semiconductor layer is deposited onto the deposition surface of the substrate 11 as the substrate 11 passes therethrough; a second deposition chamber 30 in which an intrinsic amorphous semiconductor layer is deposited atop the p-type alloy layer on the deposition surface of the substrate 11 as the substrate 11 passes therethrough; and a third deposition chamber 32 in which an n-type conductivity semiconductor layer is deposited atop the intrinsic layer ont he deposition surface of the substrate 11 as the substrate 11 passes therethrough. It should be apparent that, (1) although only one triad of the deposition chambers has been illustrated, additional triads or additional individual chambers may be added to the apparatus to provide the machine with the capability of producing semiconductor cells having any number of p-i-n type semiconductor layers; (2) the composite substrate 11 may be utilized with any type of deposition apparatus adapted to deposit semiconductor material for use in the fabrication of electronic devices; (3) the substrate supply core 19a and the substrate take-up core 19b are shown as disposed in the deposition chambers for illustrative purposes only, while in reality the cores would be housed in separate chambers operatively connected to the deposition chambers; and (4) although the glow discharge technique illustrated herein employs cathodes energized by r.f. power, other glow discharge techniques such as the use of microwave frequencies, may be employed.

Each deposition chamber 28, 30 and 32 of the triad is adapted to deposit a single semiconductor layer, by glow discharge deposition into the substrate 11. To that end, each of the deposition chambers 28, 30 and 32 includes: a cathode 34; a shield 35 disposed about each of the cathodes 34; a process gas supply conduit 36 for introducing process gas mixtures into the area adjacent the cathodes; a power source 38 such as an alternating current generator; an evacuation conduit 41 for removing unused or spent process gases and nondeposited plasma components; a plurality of transversely extending magnetic elements 50; a plurality of radiant heating elements shown schematically as 40; and a gas gate 42 operatively connecting the intrinsic deposition chamber to each of the dopant chambers. Further, inert sweep gas conduits 37 are disposed on opposed sides of the intrinsic deposition chamber 30 for establishing a unidirectional flow of inert gas through the gas gates 42. Although the gas gates 42 are depicted as establishing a unidirectional flow of inert gas, the gas gates 52 may also have other types of internal flow of sweep gas established as long as the flow operates to prevent diffusion of process gas between the adjacent deposition chambers.

The supply conduits 36 are operatively associated with the respective cathodes 34 to deliver process gas mixtures to the plasma regions which are created in each deposition chamber between said cathodes 34 and the substrate 11. The cathode shields 35 are adapted to operate in conjunction with the web of substrate material 11 and the evacuation conduit 41 to substantially confine the plasma within the cathode region of the deposition chambers.

The alternating current generators 38 operate in conjunction with the cathodes 34, the radiant heaters 40 and the grounded substrate 11 to form the plasma, and disassociate the process gases entering the plasma region of the deposition chambers into deposition species. The deposition species are then deposited onto the bottom surface of the substrate 11 as amorphous semiconductor layers. The substrate 11 may be maintained substantially flat by the plurality of rows of magnetic elements 50 which provide an attractive force urging the substrate upwardly, out of its normal sagging path of travel.

To form the photovoltaic cell 10 illustrated in Figure 1, a p-type semiconductor layer is deposited onto the substrate 11 in the deposition chamber 28, an intrinsic amorphous semiconductor layer is deposited atop the p-type layer in the deposition chamber 30, and an n-type semiconductor layer is deposited atop the intrinsic layer in the deposition chamber 32. As a result, the apparatus 26 deposits at least three successive semiconductor layers onto the substrate 11, wherein the intrinsic layer deposited in deposition chamber 30 differs in composition from the layers deposited in deposition chambers 28 and 32 by the absence of at least one element which will be referring to as the dopant or doping species.

### III. The Composite Substrate

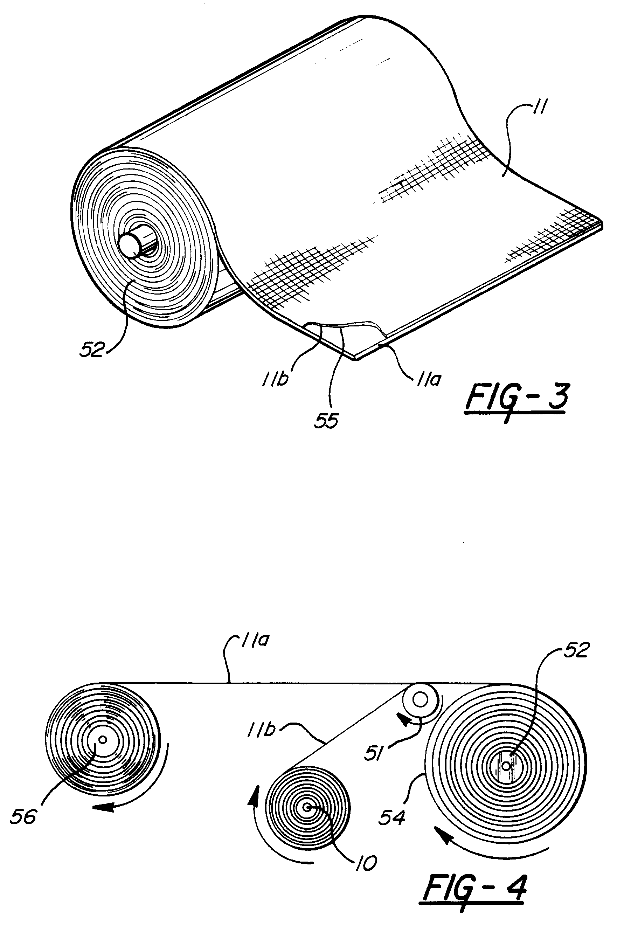

The composite substrate 11 forms the base or foundation upon which the layers of semiconductor material making up the photovoltaic device 10 are subsequently deposited. Accordingly, the composite substrate must be of an acceptable morphological quality if the electronic device 10 is to perform in an optimum manner. While the foregoing description dealt with the deposition of semiconductor layers for the fabrication of a photovoltaic cell, the composite substrate 11, described herein, is equally well-suited for providing support and electrical isolation for the fabrication of other electronic devices through the deposition thereonto of other electronic circuit elements as, for example, by a metallization step. The composite substrate 11 illustrated in conjunction with the photovoltaic device shown in Figure 1 is best seen in Figure 3. Composite substrate 11 is a bi-layer structure comprised of two layers: a layer of relatively rigid, relatively thick support material 11a and a layer of electrically insulating material 11b disposed atop support layer 11a. Support layer 11a is preferably formed of a metallic material, most typically sheet stainless steel. Other useful metals are aluminum, brass or steel. A particularly useful composition of stainless steel for this purpose is known as Bright Annealed 430, and is manufactured by the Nikken Company of Japan. The support layer 11a must be thick enough to support the layers of semiconductor material to be deposited thereon, but must be thin enough so that the semiconductor devices may be fabricated in a continuous roll-to-roll process. These two requirements are met when the stainless steel substrate 11a has a thickness of between five to ten mils. Note that the use of a stainless steel substrate provides for magnetically flattening the web of substrate material as it passes through the plurality of interconnected deposition chambers referred to hereinabove. This allows the size of the slits through which the web passes to be minimized, thereby reducing cross-contamination of gases between adjacent chambers.

Insulating layer 11b is typically characterized by a material having high dielectric strength, good adhesion to support layer 11a, and a smooth surface finish, and possessing the capability of being coated by relatively thin contiguous electronic layers of uniform surface quality. Particularly suited for the present purposes are polymeric resins which exhibit the following properties: good dimensional stability so that the material will not deform during the roll-to-roll processing; creep resistance; impact resistance; sufficient thermal stability to withstand temperatures up to 350° C typically encountered during the semiconductor fabrication process; good mechanical properties at these temperatures; good electrical insulating properties to prevent short circuiting between discrete areas of semiconductor material, and between the support layer 11a and the semiconductor elements; and low vapor pressure at elevated temperatures to prevent outgassing from the polymer when the composite substrate 11 is subjected to the vacuums typically encountered during semiconductor fabrication. It has been found that polyamide (amide) film such as that sold under the trade name Kapton® exhibits such properties. Other useful polymers are polyamide XU218 and polyamide XU218HP, both manufactured by the Ciba-Geigy Corporation. The insulating layer 11b has a layer of thermoplastic high temperature, hot-melt adhesive 55 deposed thereon. A particularly suitable hot-melt adhesive for use on the Kapton® film is Teflon® (PTFE) or any other suitable fluoroethylene polymer. The thickness of the insulating layer 11b is approximately 1 mil.

The process steps for manufacturing the composite substrate 11 are schematically illustrated in Figure 4. In a preferred embodiment, an elongated sheet of support material 11a and an elongated sheet of insulating material 11b are provided in roll form wound around, respectively, rollers 56 and 70. (While the insulating material 11b and the support material 11a are preferably provided in roll form, in secondary, albeit equally preferred embodiments, they may be provided in sheet form without departing from the spirit or scope of the instant invention.) The two layers of sheet material 11a, 11b are simultaneously unwound from, respectively, rollers 56 and 70. Support layer 11a is maintained under a tensioning force of at least about 200 lbs. during the fabrication of the composite substrate 11. The level of tension is maintained by adjusting of the speeds of the rotating pay-out roller 56 and take up roller 52, around which the composite substrate 11 is wound, in a manner well known in the art. Rollers 56 and 70 are simultaneously wound together onto take up roller 52. The insulating layer 11a may, although not necessarily, first pass over idler roller 51. It is to be noted that idler roller 51 is preferably omitted so that the deposition surface of the web is not creased or otherwise marred. In this manner, a composite roll substrate material 54 is formed of interwound alternating layers of support material 11a and insulating material 11b wound under tension around take up roller 52. The tensioning force placed on support layer 11a as it is interwound with insulating layer 11b from roller 16 to take up roller 52 expels any air pockets or air bubbles that might otherwise be trapped between the layers 11a and 11b.

After the composite roll 54 has been formed, it is heated for a period of time sufficient to activate adhesive layer 55. Typically, a heat source, such as a conventional box oven (not shown), is provided. The heat source need only be of a size sufficient to contain composite roll 54 and be capable of heating the interwound roll to the flowing temperature of the adhesive. For a Kapton® insulating layer 11a having a PTFE adhesive layer 55 deposed thereon, the temperature of the box oven is approximately 250° C. In order to activate the heat sealing properties of the hot-melt adhesive when the composite substrate is tensioned to 200 lbs., the composite roll 54 remains in the box oven for a period of approximately 30 to 60 minutes. Of course, the temperature can be reduced if the tension or the time is increased or the temperature and time can be increased if the tension is reduced. In other words, the skilled artisan can manipulate pressure, time and temperature parameters in order to optimize the bond between the insulating material and the support material.

After the roll of composite substrate 54 is removed from the heat, it is available in roll form for the continuous roll-to-roll semiconductor fabrication in the manner discussed previously, or in any other well known roll-to-roll method. Such continuous processing systems are disclosed in, for example, U.S. Patent Nos.: 4,400,409; 4,410,588; 4,438,723; 4,492,181; and 4,485,125. Although production of a p-i-n amorphous silicon alloy photovoltaic device has been described, by suitable arrangement of the discrete, dedicated, interconnected deposition chambers; photovoltaic devices of other configurations may be produced, such as, without limitation, n-i-p cells, Schottky barriers, photodiodes, phototransistors, multiple stacked cells of various configurations, or other types of semiconductor devices, without departing from the spirit or scope of the instant invention. Also, cadmium sulfide, cadmium telluride, copper indium diselinide, etc. photovoltaic devices may advantageously employ the teachings of the present invention. All of the foregoing are thin film devices and may be produced in a continuous roll-to-roll, multiple deposition chamber process and, thus, find particular compatibility with the method of the present invention.

It is noteworthy that the lamination process disclosed herein is also applicable as a method of laminating an encapsulating top layer unto the exposed surface of a thin film semiconductor device, such as a thin film transistor or a diode.

### IV. The Method of Encapsulating the Photovoltaic Device

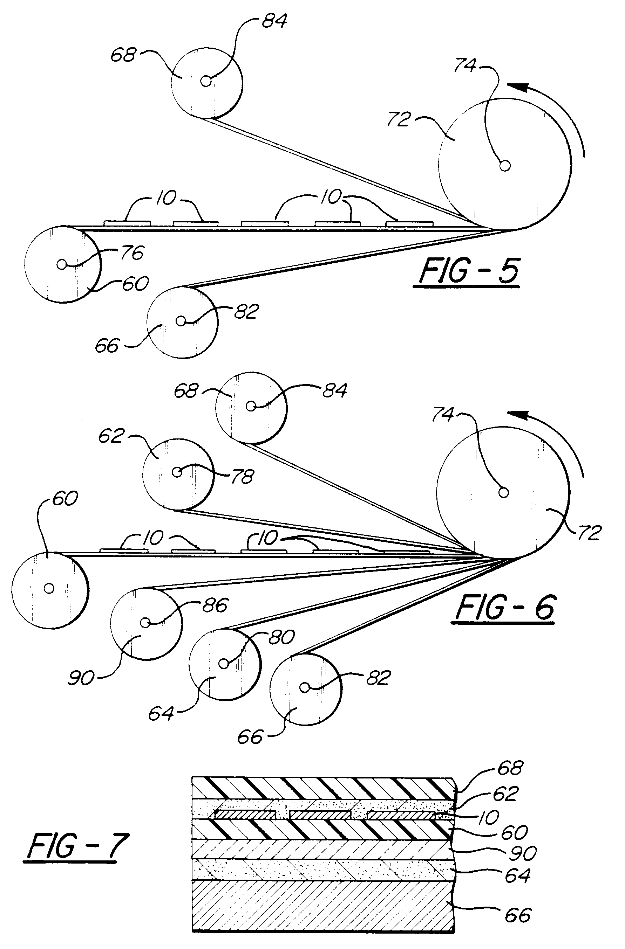

The process steps for encapsulating the photovoltaic device 10 are schematically illustrated in Figures 5 and 6. As shown in Figure 5, an elongated sheet of a first adhesive material 60 is provided in roll form wound around a roller 76 and the photovoltaic device 10 is disposed along an unrolled portion of the first adhesive material 60. The adhesive is a heat-activatable adhesive such as a hot-melt adhesive, cross-linking adhesive or a thermally activated epoxy or urethane adhesive. The photovoltaic devices may comprise discrete devices, or may comprise a plurality of devices electrically interconnected in a series and/or parallel electrical relationship. An elongated sheet of back encapsulant material 66 and an elongated sheet of front encapsulant material 68 are also provided in roll form wound around rollers 82 and 84, respectively, and a portion of each is unrolled. (It should be noted that while the encapsulant and adhesive materials are preferably provided in roll form, in secondary, albeit equally preferred embodiments, they may be provided in sheet form without departing from the spirit or scope of the instant invention.)

The materials so provided are interleaved and simultaneously wound together onto a common take-up roller 74 to create a composite, layered structure 72 comprising, in order, front encapsulant material 68, photovoltaic device 10, first adhesive material 60, and back encapsulant material 66. Tension is maintained on the rolls of back encapsulant material 66, front encapsulant material 68, and the first adhesive material 60 while the composite structure 72 is being wound onto the common take-up roller 74 so that the resultant roll of composite structure 72 that encapsulates the photovoltaic device 10 is tightly wound and free from air pockets or air bubbles. The level of tension is maintained by adjusting the drag on the rotating pay-out rollers 76, 82, and 84 and the speed of the common take-up roller 74, around which the composite structure 72 is wound, in a manner well known in the art.

Once all the layers of material have been interleaved and wound together, the entire composite layered structure 72 is heated for a period of time sufficient to activate the adhesive material so as to laminate the photovoltaic device 10, between the encapsulant layers 66,68. Typically, a heat source, such as a conventional box oven (not shown) is provided. The heat source need only be of a size sufficient to contain the composite layered structure 72 and maintain a temperature of at least 120°C. In order to activate the heat sealing properties of the hot-melt adhesive, the composite structure 72 remains in the box oven for a period of approximately 10 to 30 minutes. Of course, the temperature can be reduced if the tension or the time is increased or the temperature and time can be increased if the tension is reduced. In other words, the skilled artisan can manipulate pressure, time, and temperature parameters in order to optimize the bond between the encapsulating layers 66 and 68, the first adhesive layer 60, and the photovoltaic device 10. It should be noted that in some instances, it may be desirable to subject the rolled structure to a low pressure treatment either before, or during, the heating step. This treatment removes any trapped air.

The photovoltaic device 10 may be provided in the form of a single, continuous solar panel, or as a plurality of interconnected solar subcells as shown in Figures 5 and 6. The roll of front encapsulant material 68 is, in the preferred embodiment, a transparent, synthetic, organic polymeric material. For example, a transparent fluorocarbon polymer may be used. The back encapsulant material 66 may be either a synthetic polymeric material, or a metal such as galvanized steel or aluminum. The first adhesive material 60 is a thermally activated adhesive. In the preferred embodiment, the first adhesive material 60 is ethylene vinyl acetate (EVA).

As is illustrated in Figure 6, additional layers may be added to further protect the photovoltaic device 10 and facilitate the encapsulating process. For example, an elongated sheet of second adhesive material 62 may be provided in roll form wound around a roller 78. A portion of the second adhesive material 62 may be unwound and interleaved between the front encapsulant material 68 and the photovoltaic device 10 to assist in bonding. Furthermore, an elongated sheet of dielectric material 70 may also be provided in roll form wound around a roller 86 such that a portion of the dielectric material 90 may be unwound and layered in between the first adhesive material 60 and the back encapsulant material 66. The dielectric layer is preferably included when the rear encapsulant is electrically conductive. Nylon mesh is one preferred dielectric material. If it is so desired, an elongated sheet of a third adhesive material 64 may also be provided in roll form wound around a roller 80 to bond the dielectric material 90 to the back encapsulant material 66. The second and third adhesive materials 62 and 64 are also thermally activated adhesives such as ethylene vinyl acetate (EVA).

Optionally, the front encapsulant material 68 may be pretreated with the second adhesive material 62 before layering it into the composite structure 72 to encapsulate the photovoltaic device 10. Likewise, the dielectric material 90 may be pretreated with the third adhesive material 64 prior to layering and rolling the dielectric material 70 into the composite layered structure 72 to encapsulate the photovoltaic device 10. In keeping with the spirit of the present invention, still other layers may be similarly interposed.

Figure 7 illustrates a cross-sectional view of the composite layered structure 72 that encapsulates the photovoltaic device 10 after the heating process has been completed. The composite structure 72 in Figure 5 illustrates a front encapsulant material 68 and a second adhesive material 62 atop the photovoltaic cells 10 which are positioned on the first adhesive material 60. The first adhesive material 60 upon which the photovoltaic cells 10 sit is supported by dielectric material 90, a layer of third adhesive material 64 and finally a back encapsulant layer 66. The back encapsulant 66 shown in Figure 5 is galvanized steel.

The foregoing descriptions and drawings are directed to particular embodiments which are illustrative of the principles of the instant invention, and are not intended to be limitations thereupon. It is the following claims, including all equivalents, which are intended to define the scope of the invention.

## Claims

1. A method of producing a roll of semiconductor material which includes a composite substrate formed of an electrically insulating material bonded onto a support layer, said method comprising the steps of:
providing a roll of support material (11a);
providing a roll of insulating material (11b);
unwinding the roll of support material (11a) while subjecting the support material to a tensioning force and simultaneously unrolling the roll of insulating material (11b);
interwinding the tensioned support material and the insulating material together on a common take up roller (52) to form a composite roll (54) of alternating layers of tensioned support material and insulating material;
providing a source of heat;
exposing the composite roll (54) to the heat source for a time period sufficient to bond the insulating material to the support material to form a composite substrate;
removing the roll of composite substrate from the heat source;
unwinding the roll of composite substrate;
depositing successive layers of semi conductor material (16a-c, 18a-c, 20a-c) atop the insulating material (11b) as the composite roll (54) is continuously moved through a plurality of deposition zones (28, 30, 32), so as to fabricate a roll (19b) of semiconductor devices (10);
severing a semiconductor device (10) from said roll of semiconductor devices;
providing a first roll of adhesive material (60);
unwinding a portion of said first adhesive roll;
disposing said semiconductor device (10) on said unwound portion of the first adhesive roll (60);
providing a roll of back encapsulant material (66);
unwinding a portion of said back encapsulant material roll;
providing a roll of front encapsulant material (68);
unwinding a portion of said front encapsulant material roll;
interleaving said materials so as to provide a layered structure comprising, in order, front encapsulant material (68), semiconductor device (10), first adhesive material (60), and back encapsulant material (66);
rolling up said layered structure while maintaining tension on said rolls of materials so as to provide a tightly wound composite roll of said layered structure (72); and
heating said roll of layered structure for a period of time sufficient to activate said adhesive material.

2. The method of claim 1 including the further steps of depositing an adhesive layer on the insulating material, and exposing the composite substrate to the heat source for a time period sufficient to activate the adhesive.

3. The method of claim 2 including the step of depositing an adhesive which is a thermoplastic, high temperature, hot-melt adhesive.

4. The method of claim 1 including the further step of providing a support material which is a metal.

5. The method of claim 1 wherein the step of exposing the composite substrate to the source of heat comprises disposing the composite substrate in a dry oven maintained at a temperature of at least 250°C for a time period of between 30 to 60 minutes.

6. The method of claim 1 wherein the step of subjecting the support material to a tensioning force includes the step of providing a tensioning force of at least 890N (200 lbs).

7. A method of manufacturing an encapsulated photovoltaic device, said method including the steps of:
providing a flexible, thin film photovoltaic device (10);
providing a first roll of adhesive material (60);
unwinding a portion of said first adhesive roll, while maintaining said first roll under tension;
disposing said photovoltaic device (10) on said unwound portion of the tensioned first adhesive roll (60) such that said portion supports said device;
providing a roll of flexible back encapsulant material (66);
unwinding a portion of said flexible back encapsulant material roll, while maintaining said back encapsulant roll under tension;
providing a roll of front encapsulant material (68);
unwinding a portion of said front encapsulant material roll, while maintaining said front encapsulant roll under tension;
interleaving said materials so as to provide a layered structure comprising, in order, front encapsulant material (68), photovoltaic device (10), first adhesive material (60), and back encapsulant material (66);
rolling up said layered structure while maintaining tension on said rolls of material so as to flex said photovoltaic device and to provide a tightly wound composite roll of said layered structure (72); and
heating said roll of layered structure (72) for a period of time sufficient to activate said adhesive material.

8. The method of claim 7 including the further steps of:
providing a roll of second adhesive material;
unwinding a portion of said roll of second adhesive material; and
interleaving said materials so as to provide a layered structure comprising, in order, front encapsulant material, second adhesive material, photovoltaic device, first adhesive material, and back encapsulant material.

9. The method of claim 7 wherein the step of providing a roll of front encapsulant material includes providing a roll of front encapsulant material pretreated with second adhesive material.

10. The method of claim 7 including the further steps of:
providing a roll of dielectric material;
unwinding a portion of said roll of dielectrict material; and
interleaving said roll of dielectric material into the layered structure between the first adhesive material and the back encapsulant material.

11. The method of claim 7 wherein the step of providing a photovoltaic device comprises providing a photovoltaic device comprises providing a single, continuous solar panel.

12. The method of claim 7 wherein the step of providing a photovoltaic device comprises providing a plurality of interconnected subcells.

13. The method of claim 7 wherein the step of providing a roll of front encapsulant material comprises providing a roll of a transparent, synthetic, organic polymeric material.

14. The method of claim 7 wherein the step of heating said roll of layered structure comprises disposing said roll in an oven maintained at a temperature of at least 120°C for a time period of between 10 to 30 minutes.

15. The method of claim 7 including the further step of maintaining a tension of at least 890N (200 lbs) while rolling up said layered structure.

## Patentansprüche

1. Verfahren zur Herstellung einer Rolle eines Halbleitermaterials, das ein Verbundsubstrat einschließt, das aus einem elektrisch isolierenden Material gebildet wird, das auf eine Stützschicht bondiert wird, wobei dieses Verfahren die folgenden Schritte umfaßt:
Bereitstellen einer Rolle eines Stützmaterials (11a);
Bereitstellen einer Rolle eines Isoliermaterials (11b);
Abwickeln der Rolle des Stützmaterials (11a), wobei das Stützmaterial einer Spannkraft ausgesetzt wird, und gleichzeitiges Abwickeln der Rolle des Isoliermaterials (11b);
Aufwickeln des gespannten Stützmaterials und des Isoliermaterial zusammen auf eine gemeinsame Wickelwalze (52), um eine Verbundrolle (54) von abwechselnden Schichten des gespannten Stützmaterials und des Isoliermaterials zu bilden;
Bereitstellen einer Wärmequelle;
Aussetzen der Verbundrolle (54) der Einwirkung der Wärmequelle über eine ausreichende Zeitspanne, um das Isoliermaterial an das Stützmaterial zu binden, um ein Verbundsubstrat zu bilden;
Entfernen der Rolle des Verbundsubstrats von der Wärmequelle;
Abwickeln der Rolle des Verbundsubstrats;
Auftragen von aufeinanderfolgenden Schichten des Halbleitermaterials (16a-c, 18a-c, 20a-c) oben auf das Isoliermaterial (11b), während die Verbundrolle (54) kontinuierlich durch eine Vielzahl von Auftragungszonen (28, 30, 32) bewegt wird, um so eine Rolle (19b) von Halbleiter-Bauelementen (10) herzustellen;
Abtrennen eines Halbleiter-Bauelementes (10) von dieser Rolle von Halbleiter-Bauelementen;
Bereitstellen einer ersten Rolle eines Klebstoffs (60);
Abwickeln eines Abschnitts der ersten Klebstoff-Rolle;
Anordnen des Halbleiter-Bauelementes (10) auf diesem abgewickelten Abschnitt der ersten Klebstoff-Rolle (60);
Bereitstellen einer Rolle von Rückseiten-Verkapselungsstoff (66);
Abwickeln eines Abschnitts dieser Rolle des Rückseiten-Verkapselungsstoffs;
Bereitstellen einer Rolle von Vorderseiten-Verkapselungsstoff (68);
Abwickeln eines Abschnitts dieser Rolle des Vorderseiten-Verkapselungsstoffs;
Überlappen dieser Materialien auf eine Weise, durch die eine Schichtstruktur gebildet wird, die, in dieser Reihenfolge, den Vorderseiten-Verkapselungsstoff (68), das Halbleiter-Bauelement (10), den ersten Klebstoff (60) und den Rückseiten-Verkapselungsstoff (66) umfaßt;
Aufwickeln dieser Schichtstruktur unter Beibehaltung der Spannung an den Materialrollen, um eine fest aufgewickelte Verbundrolle der Schichtstruktur (72) zu bilden; und
Erhitzen der Rolle der Schichtstruktur über eine ausreichende Zeitspanne, um den Klebstoff zu aktivieren.

2. Verfahren nach Anspruch 1, das die weiteren Schritte des Aufbringens einer Klebeschicht auf das Isoliermaterial und des Aussetzens des Verbundsubstrats der Einwirkung der Wärmequelle über eine zur Aktivierung des Klebstoffs ausreichende Zeitspanne einschließt.

3. Verfahren nach Anspruch 2, das den Schritt des Aufbringens eines Klebstoffs einschließt, der ein thermoplastischer, warmfester Schmelz-Kunstharzleim ist.

4. Verfahren nach Anspruch 1, das den weiteren Schritt des Bereitstellens eines Stützmaterials einschließt, das ein Metall ist.

5. Verfahren nach Anspruch 1, bei dem der Schritt des Aussetzens des Verbundsubstrats der Einwirkung der Wärmequelle die Anordnung des Verbundsubstrats in einem Trockenofen, der bei einer Temperatur von wenigstens 250°C gehalten wird, über eine Zeitspanne von zwischen 30 und 60 Minuten einschließt.

6. Verfahren nach Anspruch 1, bei dem der Schritt des Aussetzens des Stützmaterials der Einwirkung einer Spannkraft den Schritt der Bereitstellung einer Spannkraft von wenigstens 890 N (200 pounds) einschließt.

7. Verfahren zur Herstellung eines eingekapselten, photovoltaischen Bauelementes, wobei das Verfahren die folgenden Schritte einschließt:
Bereitstellen eines flexiblen photovoltaischen Dünnfilm-Bauelementes (10);
Bereitstellen einer ersten Rolle eines Klebstoffs (60);
Abwickeln eines Abschnitts dieser ersten Klebstoff-Rolle, wobei diese erste Rolle unter Spannung gehalten wird;
Anordnen des photovoltaischen Bauelementes (10) auf diesem abgewickelten Abschnitt der gespannten ersten Klebstoff-Rolle (60), so daß dieser Abschnitt das Bauelement trägt;
Bereitstellen einer Rolle eines flexiblen Rückseiten-Verkapselungsstoffs (66);
Abwickeln eines Abschnitts dieser Rolle des flexiblen Rückseiten-Verkapselungsstoffes, wobei diese Rückseiten-Verkapselungsstoff-Rolle unter Spannung gehalten wird;
Bereitstellen einer Rolle eines flexiblen VorderseitenVerkapselungsstoffs (68);
Abwickeln eines Abschnitts dieser Rolle des flexiblen Vorderseiten-Verkapselungsstoffes, wobei diese Vorderseiten-Verkapselungsstoff-Rolle unter Spannung gehalten wird;
Überlappen dieser Stoffe auf eine Weise, durch die eine Schichtstruktur gebildet wird, die, in dieser Reihenfolge, den Vorderseiten-Verkapselungsstoff (68) das photovoltaische Bauelement (10), den ersten Klebstoff (60) und den Rückseiten-Verkapselungsstoff (66) umfaßt;
Aufwickeln dieser Schichtstruktur unter Beibehaltung der Spannung an diesen Materialrollen, um so das photovoltaische Bauelement zu biegen und um eine fest gewickelte Verbundrolle dieser Schichtstruktur (72) zu bilden, und
Erhitzen dieser Rolle der Schichtstruktur (72) über eine ausreichende Zeitspanne, um den Klebstoff zu aktivieren.

8. Verfahren nach Anspruch 7, das die folgenden weiteren Schritte einschließt:
Bereitstellen einer Rolle eines zweiten Klebstoffs;
Abwickeln eines Abschnitt dieser Rolle des zweiten Klebstoffs; und
Überlappen dieser Stoffe, so daß eine Schichtstruktur gebildet wird, die, in dieser Reihenfolge, den Vorderseiten-Verkapselungsstoff, den zweiten Klenstoff, das photovoltaische Bauelement, den ersten Klebstoff und den Rückseiten-Verkapselungsstoff einschließt.

9. Verfahren nach Anspruch 7, bei dem der Schritt des Bereitstellens einer Rolle des Vorderseiten-Verkapselungsstoffes die Bereitstellung einer Rolle des Vorderseiten-Verkapselungsstoffes einschließt, die mit dem zweiten Klebstoff vorbehandelt wurde.

10. Verfahren nach Anspruch 7, das die folgenden weiteren Schritte einschließt:
Bereitstellen einer Rolle eines dielektrischen Materials;
Abwickeln eines Abschnitts dieser Rolle des dielektrischen Materials; und
Einfügen dieser Rolle des dielektrischen Materials in die Schichtstruktur zwischen den ersten Klebstoff und den Rückseiten-Verkapselungsstoff.

11. Verfahren nach Anspruch 7, bei dem der Schritt des Bereitstellen eines photovoltaischen Bauelementes die Bereitstellung einer einzelnen, kontinuierlichen Solarzellen-Fläche umfaßt.

12. Verfahren nach Anspruch 7, bei dem der Schritt des Bereitstellens eines photovoltaischen Bauelementes die Bereitstellung einer Vielzahl von untereinander verbundenen Unterzellen umfaßt.

13. Verfahren nach Anspruch 7, bei dem der Schritt des Bereitstellens einer Rolle eines Vorderseiten-Verkapselungsstoffes die Bereitstellung einer Rolle eines transparenten, synthetischen, organischen polymeren Stoffes umfaßt.

14. Verfahren nach Anspruch 7, bei dem der Schritt des Erhitzens der Rolle der Schichtstruktur die Anordnung dieser Rolle in einem Ofen, der bei einer Temperatur von wenigstens 120°C gehalten wird, für eine Zeitspanne von zwischen 10 und 30 Minuten umfaßt.

15. Verfahren nach Anspruch 7, das den weiteren Schritt des Beibehaltens einer Spannung von wenigstens 890 N (200 pounds) einschließt, während die Schichtstruktur aufgewickelt wird.

## Revendications

1. Procédé de production d'un rouleau de matériau semiconducteur englobant un substrat composite composé d'un matériau à isolation électrique fixé sur une couche de support, ledit procédé comprenant les étapes ci-dessous:
fourniture d'un rouleau de matériau de support (11a);
fourniture d'un rouleau de matériau isolant (11b);
déroulement du rouleau de matériau de support (11a) tout en soumettant le matériau de support à une force de tension et en déroulant simultanément le rouleau de matériau isolant (11b);
enroulement réciproque du matériau de support tendu et du matériau isolant ensemble sur un enrouloir (52) pour former un rouleau composite (54) de couches alternées de matériau de support tendu et de matériau isolant;
fourniture d'une source de chaleur;
exposition du rouleau composite (54) à la source de chaleur pendant une période de temps suffisante pour fixer le matériau isolant au matériau de support pour former un substrat composite;
enlèvement du rouleau du substrat composite de la source de chaleur;
déroulement du rouleau de substrat composite;
dépôt de couches successives de matériau semi-conducteur (16a-c, 18a-c, 20a-c) au-dessus du matériau isolant (11b)) pendant que le rouleau composite (54) est déplacé en continu à travers plusieurs zones de dépôt (28, 30, 32), de sorte à produire un rouleau (19b) de dispositifs semiconducteurs (10);
séparation d'un dispositif semi-conducteur (10) dudit rouleau de dispositifs semiconducteurs;
fourniture d'un premier rouleau de matériau adhésif (60);
déroulement d'une partie dudit premier rouleau adhésif:
agencement dudit dispositif semiconducteur (10) sur ladite partie déroulée du premier rouleau adhésif (60);
fourniture d'un rouleau de matériau d'encapsulage arrière (66);
déroulement d'une partie dudit rouleau de matériau d'encapsulage arrière;
fourniture d'un rouleau de matériau d'encapsulage avant (68);
déroulement d'une partie dudit rouleau d'encapsulage avant;
intercalation desdits matériaux, de sorte à fournir une structure à couches comprenant successivement le matériau d'encapsulage avant (68), le dispositif semiconducteur (10), le premier matériau adhésif (60) et le matériau d'encapsulage arrière (66);
enroulement de ladite structure à couches, tout en maintenant sous tension lesdits rouleaux de matériau, de sorte à fournir un rouleau composite fermement enroulé de ladite structure à couches (72); et
chauffage dudit rouleau de structure à couches pendant une période de temps suffisante pour activer ledit matériau adhésif.

2. Procédé selon la revendication 1, englobant les étapes ultérieures de dépôt d'une couche adhésive sur le matériau isolant et d'exposition du substrat composite à la source de chaleur pendant une période de temps suffisante pour activer l'adhésif.

3. Procédé selon la revendication 2, englobant l'étape de dépôt d'un adhésif qui est un adhésif thermoplastique, à haute résistance à chaud et thermofusible.

4. Procédé selon la revendication 1, englobant l'étape ultérieure de fourniture d'un matériau de support qui est du métal.

5. Procédé selon la revendication 1, dans lequel l'étape d'exposition du substrat composite à la source de chaleur comprend l'agencement du substrat composite dans un four de séchage maintenu à une température d'au moins 250°C pendant une période de temps comprise entre 30 et 60 minutes.

6. Procédé selon la revendication 1, dans lequel l'étape de l'exposition du matériau de support à une force de tension englobe l'étape de fourniture d'une force de tension d'au moins 890 N (200 livres).

7. Procédé de production d'un dispositif photovoltaïque encapsulé, ledit procédé englobant les étapes ci-dessous:
fourniture d'un dispositif photovoltaïque flexible à couche mince (10);
fourniture d'un premier rouleau de matériau adhésif (60);
déroulement d'une partie dudit premier rouleau adhésif tout en maintenant sous tension ledit premier rouleau;
agencement dudit dispositif photovoltaïque (10) sur ladite partie déroulée du premier rouleau adhésif sous tension (60), de sorte que ladite partie supporte ledit dispositif;
fourniture d'un rouleau de matériau d'encapsulage arrière flexible (66);
déroulement d'une partie dudit rouleau de matériau d'encapsulage arrière flexible tout en maintenant sous tension ledit rouleau d'encapsulage arrière;
fourniture d'un rouleau de matériau d'encapsulage avant (68);
déroulement d'une partie dudit rouleau d'encapsulage avant tout en maintenant sous tension ledit rouleau de matériau d'encapsulage avant;
intercalation desdits matériaux, de sorte à fournir une structure à couches comprenant successivement le matériau d'encapsulage avant (68), le dispositif photovoltaïque (10), le premier matériau adhésif (60) et le matériau d'encapsulage arrière (66);
enroulement de ladite structure à couches, tout en maintenant sous tension lesdits rouleaux de matériau, de sorte à fléchir ledit dispositif photovoltaïque et à fournir un rouleau composite fermement enroulé de ladite structure à couches (72); et
chauffage dudit rouleau de structure à couches (72) pendant une période de temps suffisante pour activer ledit matériau adhésif.

8. Procédé selon la revendication 7, englobant les étapes ultérieures ci-dessous:
fourniture d'un rouleau d'un deuxième matériau adhésif;
déroulement d'une partie dudit rouleau du deuxième matériau adhésif; et
intercalation desdits matériaux, de sorte à fournir une structure à couches comprenant successivement le matériau d'encapsulage avant, le deuxième matériau adhésif, le dispositif photovoltaïque, le premier matériau adhésif et le matériau d'encapsulage arrière.

9. Procédé selon la revendication 7, dans lequel l'étape de fourniture d'un rouleau de matériau d'encapsulage avant englobe la fourniture d'un rouleau de matériau d'encapsulage avant prétraité avec un deuxième matériau adhésif.

10. Procédé selon la revendication 7, englobant les étapes ultérieures ci-dessous:
fourniture d'un rouleau de matériau diélectrique;
déroulement d'une partie dudit rouleau de matériau diélectrique; et
intercalation dudit rouleau de matériau diélectrique dans la structure à couches, entre le premier matériau adhésif et le matériau d'encapsulage arrière.

11. Procédé selon la revendication 7, dans lequel l'étape de fourniture d'un dispositif photovoltaïque comprend la fourniture d'un seul panneau de cellules solaires continu.

12. Procédé selon la revendication 7, dans lequel l'étape de fourniture d'un dispositif photovoltaïque comprend la fourniture de plusieurs sous-cellules interconnectées.

13. Procédé selon la revendication 7, dans lequel l'étape de fourniture d'un rouleau de matériau d'encapsulage avant comprend la fourniture d'un rouleau d'un matériau transparent, synthétique, organique et polymère.

14. Procédé selon la revendication 7, dans lequel l'étape de chauffage dudit rouleau de structure à couches comprend l'agencement dudit rouleau dans un four maintenu à une température d'au moins 120°C pendant une période de temps comprise entre 10 et 30 minutes.

15. Procédé selon la revendication 7, englobant l'étape ultérieure de maintien d'une tension d'au moins 890 N (200 livres) lors de l'enroulement de ladite structure à couches.
